(19) Europäisches Patentamt / European Patent Office / Office européen des brevets

(11) EP 2 899 246 A2

(12) **EUROPEAN PATENT APPLICATION**

(43) Date of publication:
29.07.2015 Bulletin 2015/31

(51) Int Cl.:
*C09K 3/14* (2006.01)          *H01L 21/304* (2006.01)

(21) Application number: 14004154.2

(22) Date of filing: 09.12.2014

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(30) Priority: 24.12.2013 JP 2013266114

(71) Applicant: Asahi Glass Company, Limited
Tokyo 100-8405 (JP)

(72) Inventors:
• Yoshida, Yuiko
Tokyo, 100-8405 (JP)
• Yoshida, Iori
Tokyo, 100-8405 (JP)

(74) Representative: Müller-Boré & Partner
Patentanwälte PartG mbB
Friedenheimer Brücke 21
80639 München (DE)

(54) **Manufacturing method of polishing agent, polishing method, and manufacturing method of semiconductor integrated circuit device**

(57)     There are provided a manufacturing method of a polishing agent capable of suppressing occurrence of a polishing defect to a surface to be polished and of performing CMP at a high polishing speed, and a polishing method. The manufacturing method of the polishing agent is a manufacturing method including injecting a slurry containing cerium oxide particles and water at a predetermined injecting pressure and colliding the injected slurry against the slurry each other or against a rigid body with a modified Mohs hardness of 8 or more so that a rate of change of an average primary particle diameter of the cerium oxide particles before and after collision may become within 20%.

EP 2 899 246 A2

**Description**

FIELD

Embodiments of the present invention disclosed here relate generally to a manufacturing method of a polishing agent, a polishing method using that polishing agent, and a manufacturing method of a semiconductor integrated circuit device in which that polishing method is used.

BACKGROUND

Because of a tendency of high density and high definition of a semiconductor element, development of a higher microfabrication technique is demanded in recent years. Conventionally, in manufacturing of a semiconductor integrated circuit device (hereinafter, also referred to as a semiconductor device), planarization of an interlayer insulation layer, a copper-embedded wiring, or the like has been carried out by using chemical mechanical polishing (hereinafter, referred to as CMP), in order to prevent a problem that unevenness (level difference) of a layer surface exceeds a depth of focus of lithography and hampers obtaining a sufficient resolution. Importance of such planarization by CMP increases all the more as a demand for high resolution or miniaturization of a semiconductor element becomes severer.

Further, in manufacturing of a semiconductor device, a separation method (shallow trench isolation, hereinafter, referred to as STI) by a shallow trench with a small element isolation width is introduced in recent years in order to advance more sophisticated miniaturization of a semiconductor element.

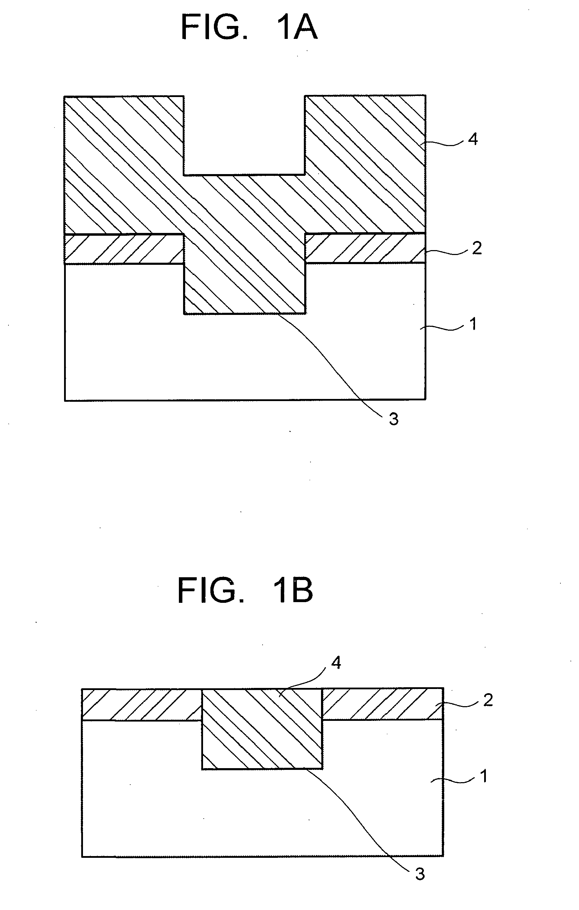

STI is a technique to form an electrically insulated element region by forming a trench in a silicon substrate and embedding an insulation layer in the trench. In STI, first, as shown in Fig. 1A, after an element region of a silicon substrate 1 is masked by a silicon nitride layer 2 or the like, a trench 3 is formed in the silicon substrate 1 and an insulation layer such as a silicon oxide layer 4 or the like is deposited in a manner to fill the trench 3. Next, by CMP, the silicon oxide layer 4 on the silicon nitride layer 2 being a protruding portion is polished and removed while the silicon oxide layer 4 in the trench 3 being a depressed portion is left, whereby an element isolation structure in which the silicon oxide layer 4 is embedded in the trench 3 is obtained as shown in Fig. 1B. In CMP in STI as above, by a configuration where a selection ratio (polishing speed of silicon oxide layer / polishing speed of silicon nitride layer) between a polishing speed of the silicon oxide layer 4 and a polishing speed of the silicon nitride layer 2 is made sufficiently high so that polishing may finish at a time that the silicon nitride layer 2 is exposed, a smoother surface can be obtained.

In manufacturing of a semiconductor device, other than planarization of the silicon oxide layer in STI as above, CMP is carried out by using a polishing agent which contains abrasive particles of fumed silica base, colloidal silica base, alumina base, ceria (cerium oxide) base or the like, in order to planarize an insulation layer of a silicon oxide or the like, or a ferroelectric layer for capacitor formed by various methods such as plasma-CVD (chemical vapor deposition), low pressure-CVD, sputtering, and electroplating. As miniaturization and high definition of an element advances, a defect (hereinafter, referred to as a polishing defect) formed in an interlayer insulation layer or an insulation layer for STI at a time of polishing, which defect causes wiring short circuit or the like and leads to reduction of a yield, becomes increasingly a large problem.

Conventionally, when a surface to be polished is an insulation layer made of a silicon oxide or the like, a polishing agent which contains high-purity cerium oxide particles have been used since the high-purity cerium oxide particles have lower hardness compared with silica-based abrasive particles and hard to cause a polishing defect (for example, see Patent Reference 1).

However, in response to further miniaturization of a semiconductor integrated circuit, demand for prevention of a polishing defect becomes further higher, and the polishing agent described in Patent Reference 1 cannot sufficiently respond to such demand. Thus, it is suggested to make a particle diameter of a cerium oxide particle being an abrasive particle smaller (for example, see Patent Reference 2). However, when a cerium oxide particle with a small particle diameter is used as an abrasive particle, a polishing speed is reduced, and there is a problem that an efficiency of polishing operation is significantly worsened.

RELEVANT REFERENCES

Patent Reference

Patent Reference 1: JP-A 2000-109803
Patent Reference 2: JP-AH08-81218

SUMMARY

The present invention is made to solve the above-described problem, and an object thereof is to provide a manufacturing method of a polishing agent capable of suppressing occurrence of a polishing defect to a surface to be polished and of polishing in a short time in CMP for planarization of an insulation layer for STI, for example, a polishing method, and a manufacturing method of a semiconductor integrated circuit device.

A manufacturing method of a polishing agent of the present invention includes: injecting a slurry containing cerium oxide particles and water at a predetermined injecting pressure; and colliding the injected slurry against the slurry each other or against a rigid body with a modified Mohs hardness of 8 or more under a condition that a rate of change of an average primary particle diameter of the cerium oxide particles before and after collision is within 20%.

In the manufacturing method of the polishing agent of the present invention, the injecting pressure at a time of injecting the slurry to collide the slurry against the rigid body or to collide the slurries against each other is preferable to be 100 MPa or more to 400 MPa or less.

Further, a concentration of the cerium oxide particles in the polishing agent is preferable to be 0.01 mass% or more to 50 mass% or less.

Further, operation of performing the injecting and the colliding in that order is preferable to be carried out one time or more to forty times or less.

A polishing method of the present invention is a method of performing polishing by a relative motion between a surface to be polished and a polishing pad which are brought into contact with each other while a polishing agent is supplied to the polishing-pad, wherein the polishing agent manufactured according to the manufacturing method of the present invention is used as the polishing agent.

A manufacturing method of a semiconductor integrated circuit device of the present invention includes polishing the surface to be polished by the polishing method of the present invention.

In the present invention, a "surface to be polished" means a surface to be polished of a polishing target, and means a front surface, for example. In manufacturing of a semiconductor device, the "surface to be polished" includes a substrate surface in an intermediate stage appearing in a manufacturing process.

According to the polishing agent and the polishing method of the present invention, it is possible to suppress occurrence of a polishing defect to a surface to be polished which includes a layer of a silicon oxide, a silicon oxide containing carbon, a silicon nitride, a silicon oxynitride, a silicon carbide, amorphous silicon, polysilicon, or the like, of a semiconductor device and to polish at a high polishing speed. Besides, it is possible to perform planarization of an insulation layer for STI, for example, at a high speed while suppressing occurrence of the polishing defect, so that a manufacturing efficiency of the semiconductor device can be heightened.

BRIEF DESCRIPTION OF DRAWINGS

Fig. 1A is a cross-sectional view of a semiconductor substrate showing a method of polishing by CMP in STI.
Fig. 1B is a cross-sectional view of the semiconductor substrate showing the method of polishing by CMP in STI.
Fig. 2 is a diagram showing an example of a jet collision apparatus usable in a manufacturing method of the present invention.
Fig. 3 is a diagram showing another example of the jet collision apparatus usable in the manufacturing method of the present invention.
Fig. 4 is a diagram showing an example of a polishing apparatus usable in a polishing method of the present invention.

DETAILED DESCRIPTION

Hereinafter, an embodiment of the present invention will be described. The present invention is not limited to the following embodiment, and another embodiment can also belong to the category of the present invention as long as the embodiment complies with the spirit of the present invention.

[Manufacturing method of polishing agent]

A manufacturing method of a polishing agent of the present invention is a method of manufacturing a polishing agent suitable for chemically mechanically polishing a surface to be polished, and includes an injecting step of injecting a slurry containing a cerium oxide particle and water at a predetermined pressure and a colliding step of colliding the injected slurry against a rigid body having a particular hardness or colliding the injected slurries against each other under a particular condition.

In the manufacturing method of the polishing agent of the present invention, first, the cerium oxide particle or the slurry containing the cerium oxide particle is prepared, for example by methods of (1) to (3) described below. The injecting step and the colliding step are applied to a slurry containing cerium oxide particles and water such as the slurry obtained by any one of the methods (1) to (3), or the slurry containing cerium oxide particles such as the cerium oxide particles by any one of the methods (1) to (3), and water.

(Manufacturing of cerium oxide particle)

The cerium oxide particle used in the manufacturing method of the present invention can be obtained by the methods shown below.

(1) After a cerium hydroxide gel is generated by adding an alkali such as an ammonia aqueous solution to a cerium (III) nitrate aqueous solution, a heating processing is carried out, whereby a slurry containing a cerium oxide particle can be obtained. The slurry obtained as above is filtrated, washed, and dried, so that the cerium oxide particle in powder form can be obtained.

(2) After a cerium hydroxide gel is generated by adding an alkali such as an ammonia aqueous solution to a cerium (IV) nitride ammonium aqueous solution, chemical oxidation is carried out, whereby a slurry containing a cerium oxide particle can be obtained. The slurry obtained as above is filtrated, washed, and dried, so that the cerium oxide particle in powder form can be obtained.

(3) A cerium (III) salt is chemically oxidized in a liquid, and a slurry containing a cerium oxide particle is obtained. The slurry obtained as above is filtrated, washed, and dried, so that the cerium oxide particle in powder form can be obtained.

(Preparation of slurry)

A slurry used in the manufacturing method of the present invention contains cerium oxide particles, for example, the cerium oxide particles obtained by the above-described method and water as a medium dispersing the cerium oxide particles. Water is not particularly limited, and pure water, ultrapure water, ion-exchange water, or the like is preferable in view of prevention of influence to another additive, contamination of impurities, and influence to a pH or the like. A content of water is preferable to be 50 mass% or more to 99.9 mass% or less in ratio to the entire slurry, and is further preferable to be 60 mass% or more to 99.8 mass% or less. Further, a content ratio of the cerium oxide particles is preferable to be 0.1 mass% or more to 50 mass% or less to the entire slurry, and is more preferable to be 0.2 mass% or more to 40 mass% or less, in view of efficiency of polishing and prevention of aggregation of particles.

The above-described slurry can be prepared by adding the aforementioned preferable amount of water to the cerium oxide particles obtained by the method selected from (1) to (3) described above, for example. Further, a later-described pH adjusting agent, dispersing agent, or the like can be added as necessary. Alternately, usable as the above-described slurry is the slurry having been generated in a stage before the cerium oxide particle is retrieved as powder, in the method selected from (1) to (3) described above.

(Injecting step and colliding step)

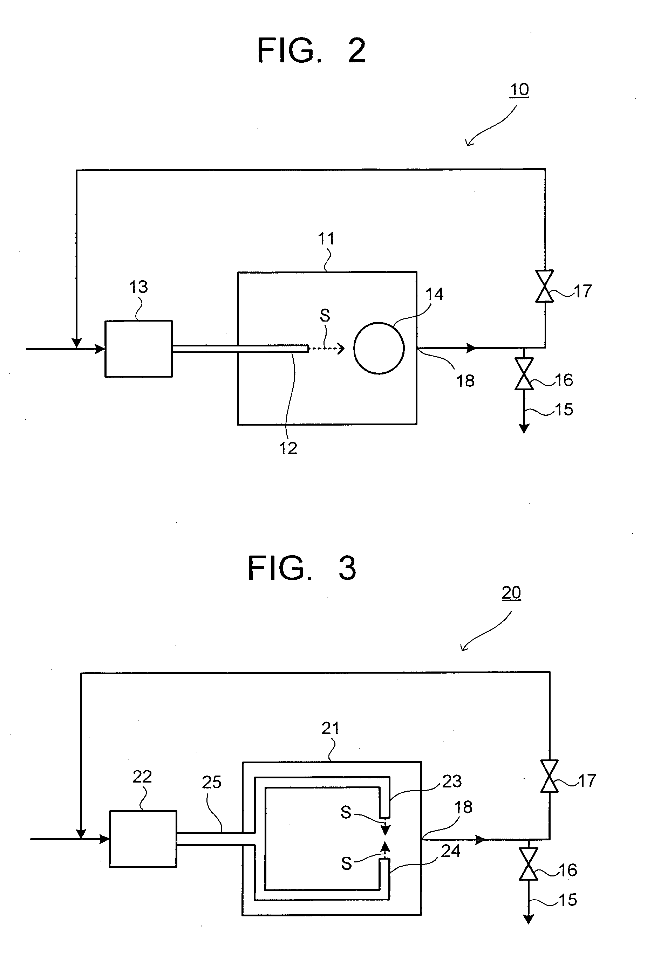

Next, the injecting step and the colliding step performed to the above-described slurry in the manufacturing method of the present invention will be described. In the present invention, the injecting step and the colliding step can be performed to the slurry by using a jet collision apparatus schematically shown in Fig. 2 or Fig. 3, for example.

A jet collision apparatus 10 shown in Fig. 2 is an example of an apparatus used in a case of injecting a slurry and colliding the injected slurry against a rigid body with a modified Mohs hardness of 8 or more. A jet collision apparatus 20 shown in Fig. 3 is an example of an apparatus used in a case of injecting a slurry and colliding the injected slurries against each other. Configurations having common functions in respective diagrams are given the same reference numerals and redundant explanation is omitted. Note that the jet collision apparatus used in an embodiment of the present invention is not limited to one having a structure of the above.

The jet collision apparatus 10 shown in Fig. 2 has a chamber 11 inside which a slurry is injected, a nozzle 12 injecting the slurry inside the chamber 11, a pressurizing supply device 13 which pressurizes the slurry fed from the outside of the chamber 11 to a predetermined pressure and supplies to the nozzle 12, and a rigid body 14 disposed inside the chamber 11. Note that the rigid body 14 is disposed in a position where the slurry injected from the nozzle 12 can collide against the rigid body 14.

When the jet collision apparatus 10 is used, the injecting step and the colliding step for the slurry are performed by injecting the slurry from the nozzle 12 inside the chamber 11 at a predetermined injecting pressure and colliding the slurry against the rigid body 14. In the jet collision apparatus 10, the injecting pressure of the slurry injected from the nozzle 12 coincides with a pressure at a time that the slurry is pressurized by the pressurizing supply device 13.

In the jet collision apparatus 10, the chamber 11 has a discharge port 18 discharging the slurry having passed through the injecting step and the colliding step (hereinafter, the injecting step and the colliding step are also combinedly referred to as "injecting colliding processing"). It is configured that the slurry discharged from the discharge port 18 is collected via a lead-out pipe 15 or supplied to the pressurizing supply device 13 to be pressurized again, being able to be injected inside the chamber 11.

More specifically, the jet collision apparatus 10 has a flow path conveying the slurry to the pressurizing supply device 13 and a flow path conveying the slurry to the lead-out pipe 15, the slurry having been subjected to the injecting colliding processing and discharged from the discharge port 18 of the chamber 11, and has valves 16, 17 switching supply of the slurry to each flow path.

The rigid body 14 has a modified Mohs hardness of 8 or more, preferably 9 or more. A shape of the rigid body 14 is not particularly limited, and a spherical shape, a column shape, a block shape, or the like can be cited. Further, a size of the rigid body 14 is not particularly limited, either. The rigid body 14 constituted with a silicon nitride, a silicon carbide, zirconia, diamond, or the like can be used. The rigid body 14 is preferable to have a high hardness and to have a low possibility of chipping and contamination. The rigid body 14 can be appropriately selected depending on a specification of the jet collision apparatus 10 to be used, a collision condition, and so on.

Further, the jet collision apparatus 20 shown in Fig 3 has a chamber 21 inside which a slurry is injected and a lead-in path 25 supplying a slurry from the outside to the inside of the chamber 21. Two flow paths branching from the lead-in path 25 are provided inside the chamber 21, and nozzles 23, 24 are provided in ends of both flow paths in directions facing each other. The jet collision apparatus 20 further has, outside the chamber 21, a pressurizing supply device 22 pressurizing the slurry to a predetermined pressure and supplying the slurry to the nozzles 23, 24 via the lead-in path 25 and the two flow paths.

The slurries having been pressurized and flowing through the above-described two paths are injected from the nozzles 23, 24 at high pressures and subjected to counter collision (facing collision) against each other, whereby the injecting colliding processing to the slurries is performed. In the jet collision apparatus 20, injecting pressures of the slurries injected from the nozzles 23, 24 coincide with a pressure at a time that the slurry is pressurized by the pressurizing supply device 22.

In this way, by using the jet collision apparatus 10 or the jet collision apparatus 20 shown in Fig. 2 or Fig. 3, for example, the injecting step and the colliding step in the manufacturing method of the present invention can be carried out.

The injecting pressure in the injecting step coincide with a pressurizing force of the pressurizing supply device 13 in a case where the slurry and the rigid body 14 are to be collided by using the jet collision apparatus 10, for example, and that pressure is preferably 100 MPa or more to 400 MPa or less, and is more preferably 150 MPa or more to 250 MPa or less.

Further, the injecting pressure in the injecting step coincide with a pressurizing force of the pressurizing supply device 22 in a case where the slurries are collided against each other by using the jet collision apparatus 20, for example, and are preferably 100 MPa or more to 400 MPa or less, and are more preferably 150 MPa or more to 250 MPa or less. As a result that the injecting pressure is within the above-described range, change of a particle diameter of a cerium oxide particle by collision of the slurry against the rigid body or of the slurries against each other in the colliding step is suppressed while sufficient energy can be obtained for heating of the particle described below. Therefore, when the slurry having passed through the injecting colliding processing is used as polishing agent for polishing the surface to be polished which includes a layer of a silicon oxide or the like, of a semiconductor device, a sufficiently large polishing speed for a silicon dioxide can be obtained and a polishing defect is hard to occur.

In the colliding step, by colliding the slurry injected as described above and the rigid body or the injected slurries against each other, kinetic energy the injected slurry has is converted into thermal energy, and the generated thermal energy heats the cerium oxide particle in the slurry Consequently, a surface state of the obtained cerium oxide is changed, and in a case where a polishing agent containing that cerium oxide is used, a sufficiently high polishing speed can be obtained even if a particle diameter of the cerium oxide particle is small when a silicon dioxide layer in STI is polished, and occurrence of a polishing defect is decreased. Further, passing through the colliding step also brings about an effect to improve dispersibility of the slurry A reason why the polishing speed is improved as above by using the cerium oxide particle having been heated by the injecting colliding processing is not necessarily obvious, but it is conceived that because OH groups the cerium oxide particles before the processing have are decreased by heating by the injecting colliding processing.

A rate of change of the average primary particle diameter of the cerium oxide particles before and after the colliding step is within 20% and is preferably within 10%. By carrying out a colliding processing to the cerium oxide particles so that the average primary particle diameter of the cerium oxide particles may have a rate of change (decrease rate) within the above-described range, it is possible to grant a sufficient polishing characteristic such as improvement of a polishing speed, or the like, to the polishing agent obtained by the manufacturing method of the present invention.

Further, in the manufacturing method of the present invention, operation of carrying out the injecting step and the colliding step in that order as described above, that is, the injecting colliding processing, can be performed to the slurry once or multiple times. When the operation is to be performed multiple times, it suffices that operation of supplying the slurry after the colliding step to the injecting step to carry out the injecting step and the colliding step again is repeated to reach the desired number of times. Note that when the injecting colliding processings are to be carried out multiple times, the jet collision apparatus 10 performing collision of the slurry and the rigid body and the jet collision apparatus 20 performing collision of the slurries against each other may be combinedly used, for example, as necessary.

The number of the operation (injecting colliding processing) of performing the injecting step and the colliding step in that order is preferable to be 1 or more to 40 or less, is more preferable to be 1 or more to 30 or less, and is further preferable to be 1 or more to 15 or less. A polishing agent obtained by setting the number of performing the injecting colliding processing to be 1 or more to 40 or less has a sufficiently large polishing speed for the surface to be polished which includes a layer of a silicon oxide or the like and is hard to generate a polishing defect.

When the injecting colliding processings are performed multiple times, a rate of change of the average primary particle diameter of the cerium oxide particles before the first injecting colliding processing and after a predetermined times of injecting colliding processings is preferable to be within 20% and is more preferable to be within 10%.

As a jet collision apparatus injecting a slurry and colliding the injected slurry against a rigid body with a modified Mohs hardness of 8 or more, such as the above-described jet collision apparatus 10, and a jet collision apparatus injecting a slurry and colliding the injected slurries against each other, such as the jet collision apparatus 20, a wet jet mill is suitable for both cases. Hereinafter, a method of colliding a slurry against a rigid body is also referred to a "rigid body collision type" and a method of colliding slurries against each other is also referred to a "counter collision type".

As the wet jet mill of counter collision type or rigid body collision type, there can be used, for example, a JN series manufactured by JOKOH CO., LTD., an ultra-high pressure wet micronization apparatus manufactured by Yoshida Industry Co., Ltd., a wet ultra micronization apparatus reMODer series manufactured by F. Planning Co., Ltd., a wet micronization apparatus manufactured by Advanced Nano Technology Co., Ltd, a Star Burst series manufactured by SUGINO MACHINE LIMITED, a wet micronization apparatus Nano-Mizer series by NANOMIZER Inc., a G-Smasher series manufactured by RIX CORPORATION, and so on.

(Preparation of polishing agent)

A content of water in the polishing agent obtained by the manufacturing method of the present invention is preferable to be in a ratio of 50 mass% or more to 99.99 mass% or less in relation to the entire polishing agent, is more preferable to be 70 mass% or more to 99.9 mass% or less, and is particularly preferable to be 90 mass% or more to 99.9 mass% or less. A content ratio of the cerium oxide particles in the polishing agent is preferable to be 0.01 mass% or more to 50 mass% or less in relation to the entire polishing agent, is more preferable to be 0.1 mass% or more to 30 mass% or less, and is particularly preferable to be 0.1 mass% or more to 10 mass% or less, in view of an efficiency of polishing and aggregation prevention of the particles.

When a content of water in the slurry subjected to the above-described injecting colliding processing is within the above-described preferable range, that slurry can be used as a polishing agent as it is. Further, it is possible to make the content of water in the polishing agent be the above-described preferable amount by adding water as necessary after the above-described injecting colliding processing is performed to the slurry

Further, a crystallite diameter XS of the cerium oxide particle in the above-described polishing agent is preferable to be 20 nm or more to 60 nm or less. Here, for the crystallite diameter XS, an X-ray diffraction spectrum of the cerium oxide particle is measured by an X-ray diffractometer and a half value width of a (111) surface is found in the obtained spectrum, and the crystallite diameter XS is calculated from that value by a formula of Scherrer shown below.

$$\text{crystallite diameter XS (nm)} = (\text{Scherrer constant} \times \text{X-ray wavelength (m)}) / (\text{half value width}$$

$$(2\theta) \times \cos \text{diffraction angle}) / 10$$

Note that as the Scherrer constant, 0.94 is used.

When the crystallite diameter XS of the cerium oxide particle in the polishing agent is 20 nm or more to 60 nm or less, a sufficiently high polishing speed for a silicon dioxide can be obtained easily and occurrence of a polishing defect can also be suppressed easily. The crystallite diameter XS of the cerium oxide particle is preferable to be 30 nm or more to 60 nm or less, and is more preferable to be 40 nm or more to 60 nm or less.

Further, an average primary particle diameter D of the cerium oxide particle in the polishing agent is preferable to be 30 nm or more to 100 nm or less, and is more preferable to be 60 nm or more to 100 nm or less. When the average primary particle diameter D is 30 nm or more to 100 nm or less, a sufficient polishing speed can be obtained easily and occurrence of a polishing defect such as a scratch in a surface to be polished can be suppressed easily. Note that when the average primary particle diameter D is less than 30 nm, there is a case where aggregation is apt to occur depending on a condition of a pH, a concentration of an additive, or the like. Here, the average primary particle diameter D is a particle diameter obtained by observation by a scanning electron microscope (SEM), and is found by image-analyzing an image of the cerium oxide particle obtained by a method of the SEM and calculating a number average particle diameter.

Further, with regard to the cerium oxide particle in the polishing agent, a ratio (XS/D) between the crystallite diameter XS and the average primary particle diameter D is preferable to be 0.4 or more to 1.0 or less. A value (XS/D) of this ratio indicates a degree (single crystallinity) of a single crystal of a cerium oxide, and the degree of the single crystal becomes higher as the value comes close to 1 (one), so that a sufficiently large polishing speed for the silicon dioxide can be obtained.

(pH)

A pH of the above-described polishing agent is preferable to be 3.5 or more to 11 or less, and is further preferable to be within a range of 3.5 or more to 10 or less. When the pH is less than 3.5, it is possible that the polishing speed is substantially reduced. Further, when the pH exceeds 11, dispersion stability of the cerium oxide particles being abrasive particles is hard to be maintained. When the pH of the polishing agent is within a range of 3.5 or more to 11 or less, dispersion stability of the cerium oxide particles is good and a high polishing speed can be obtained.

The above-described polishing agent may contain various kinds of inorganic acids or inorganic acid salts as a pH adjusting agent for adjusting the pH to be within the above-described predetermined range. The inorganic acid or the inorganic acid salt is not particularly limited, and there can be used, for example, a nitric acid, a sulfuric acid, a hydrochloric acid, a phosphoric acid, a boric acid, a carbonic acid, and an ammonium salt thereof or a potassium salt thereof, and so on.

Further, the above-described polishing agent may contain various kinds of basic compounds as the pH adjusting agent. The basic compound is preferable to be water-soluble, but is not particularly limited. It is possible to use, for example, ammonia, potassium hydroxide, and quaternary ammonium hydroxide such as tetramethylammonium hydroxide (TMAH) and tetraethylammonium hydroxide, and so on.

The above-described polishing agent can contain a component other than the above-described component. As another component, a dispersing agent or the like can be cited. The dispersing agent is contained in order to disperse cerium oxide particles stably in a dispersion medium such as pure water, and an anionic, cationic, nonionic, or amphoteric surfactant can be used. The above-described polishing agent can contain one kind or more of these components.

When the polishing agent contains the pH adjusting agent or the dispersing agent, for the pH adjusting agent or the dispersing agent the slurry as the polishing agent contains may be one contained by the slurry subjected to the injecting colliding processing in advance and may be one added to the slurry after the injecting colliding processing.

<Polishing method and polishing apparatus>

When polishing a surface to be polished which includes a layer of a silicon oxide, a silicon oxide containing carbon, a silicon nitride, a silicon oxynitride, a silicon carbide, amorphous silicon, polysilicon, or the like, of a semiconductor device by using the polishing agent obtained by the above-described manufacturing method of the present invention, a method is preferable in which polishing is performed by a relative motion between the surface to be polished and a polishing pad which are brought into contact with each other while the polishing agent is supplied to the polishing pad.

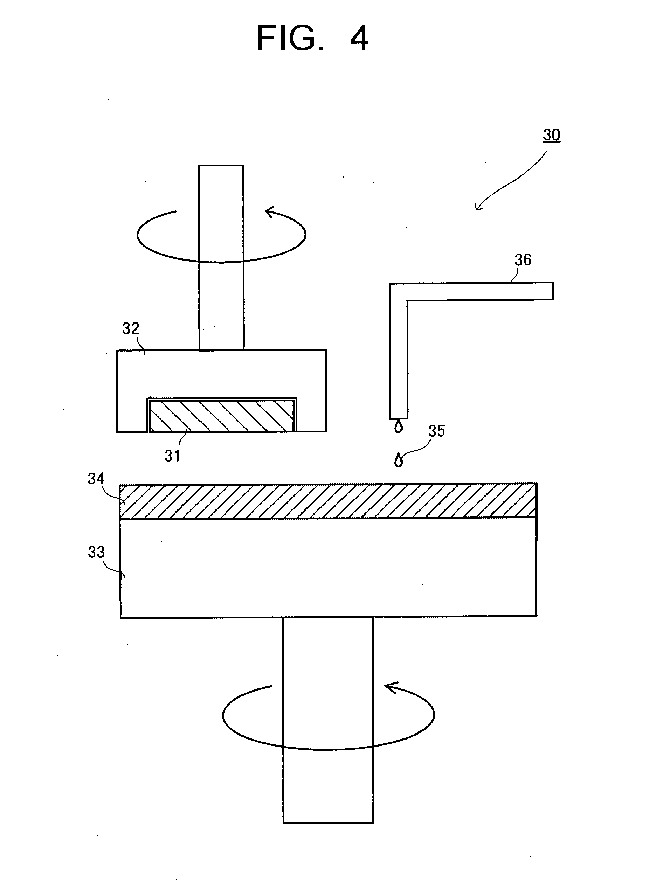

In the above-described polishing method, as for a polishing apparatus, a conventionally known polishing apparatus can be used. Fig. 4 is a diagram showing an example of the polishing apparatus usable for the polishing method of the present invention.

The polishing apparatus 30 has a polishing head 32 to hold a semiconductor device 31, a polishing platen 33, a polishing pad 34 pasted on a surface of the polishing platen 33, and a polishing agent supply piping 36 to supply the polishing agent 35 to the polishing pad 34. It is configured that a surface to be polished of the semiconductor device 31 held by the polishing head 32 is brought into contact with the polishing pad 34 to perform polishing by a relative rotational motion of the polishing head 32 and the polishing platen 33 while the polishing agent 35 is being supplied from the polishing agent supply piping 36. Note that the polishing apparatus used in the embodiment of the present invention is not limited to one having such a structure.

The polishing head 32 may make not only a rotational motion but also a linear motion. Further, the polishing platen 33 and the polishing pad 34 may have a size nearly equal to or smaller than a size of the semiconductor device 31. In that case, it is preferable to configure that an entire surface of the surface to be polished of the semiconductor device 31 is able to be polished by a relative motion of the polishing head 32 and the polishing platen 33. Further, the polishing platen 33 and the polishing pad 34 are not necessarily ones which make rotational motions, and may be ones which move in one direction by a belt system, for example.

A condition of polishing by such a polishing apparatus 30 is not particularly limited, and a polishing pressure can be further heightened to improve the polishing speed by giving a load to the polishing head 32 in pressing against the polishing pad 34. The polishing pressure is preferable to be about 0.5 kPa or more to 50 kPa or less, and is more preferable to be about 3 kPa or more to 40 kPa or less in view of uniformity, flatness, and prevention of a polishing defect such as a scratch in the surface to be polished of the semiconductor device 31 in the polishing speed. The numbers of rotations of the polishing platen 33 and the polishing head 32 are preferable to be about 50 rpm or more to 500 rpm or less, but is not limited thereto. Further, a supply amount of the polishing agent 35 is appropriately adjusted according to a composition of the polishing agent, the above-described polishing condition, and so on.

As the polishing pad 34, one made of nonwoven fabric, foamed polyurethane, a porous resin, a nonporous resin, or the like is usable. Further, in order to accelerate supply of the polishing agent 35 to the polishing pad 34 or to make a predetermined amount of the polishing agent 35 stay in the polishing pad 34, the surface of the polishing pad 34 may be subjected to a grooving processing of a lattice-shape, a concentric shape, a spiral shape, or the like. Further, as necessary, polishing may be performed while a pad conditioner is brought into contact with the surface of the polishing pad 34 to perform conditioning of the surface of the polishing pad 34.

According to the polishing method of the present invention, a surface to be polished made of a silicon oxide can be polished at a high polishing speed in a CMP processing such as planarization of an interlayer insulation layer and planarization of an insulation layer for STI in manufacturing of a semiconductor device. Further, it is possible to suppress occurrence of a polishing defect to the surface to be polished, so that a semiconductor device can be obtained at a high yield.

EXAMPLES

Hereinafter, the present invention will be described concretely based on working examples, but the present invention is not limited to the following description. Examples 1 to 7 are working examples of the present invention, while the example 8 is a comparative example. In the following examples, "%" means "mass%" unless mentioned otherwise. Further, a concentration of abrasive particles and an average primary particle diameter D, an average secondary particle diameter, and a crystallite diameter XS of cerium oxide particles were each measured by the following methods. Note that a colloidal ceria used below is a slurry containing a cerium oxide particle as an abrasive particle and water as a dispersing agent

(Concentration of abrasive particles)

A concentration of the abrasive particles was measured by using a moisture meter (manufactured by SHIMAZU CORPORATION, trade name; MOC-120H).

(Average primary particle diameter D)

An average primary particle diameter D was found by analyzing an image of a cerium oxide particle obtained by a scanning electron microscope (SEM) (manufactured by Hitachi High-Technologies Corporation, apparatus name: S-4800) by using image analysis software (manufactured by Mountech Co., Ltd, trade name: Mac-View ver. 3.5). Analysis was carried out by approximating the image of the particle to a circle, particle diameters of the 50 particles in the image were measured, and a value obtained by number-averaging was adopted as an average primary particle diameter D. Note that the average primary particle diameter D of the cerium oxide particle in the colloidal ceria was shown with an average primary particle diameter D1, while the average primary particle diameter D of the cerium oxide particle in the polishing agent was shown with an average primary diameter D2.

(Crystallite diameter XS)

For a crystallite diameter XS, an X-ray diffraction spectrum was measured by an X-ray diffractometer (manufactured by Rigaku Corporation, apparatus name: TTR-III), and the crystallite diameter XS was calculated from a half value width of an obtained (111) surface by the following formula.

crystallite diameter XS (nm) = (Scherrer constant × X-ray wavelength (m)) / (half value width

(2θ) × cos diffraction angle) / 10

Further, in preparation of the polishing agents of the examples 1 to 7, as a wet jet mill, Star Burst Mini (apparatus name) of a rigid body collision type, manufactured by Sugino Machine Ltd., was used.

Example 1

To 500 g of a colloidal ceria HC60 (trade name, manufactured by Rhodia, concentration of abrasive particles: 30%, average primary particle diameter D 1: 85 nm), an injecting colliding processing was performed once by using the above-described wet jet mill, with a pressure being set at 200 MPa. To 41.6 g of a slurry (1) obtained as above, 4958.4 g of pure water was added and mixed, to obtain a polishing agent (1) whose concentration of abrasive particles was adjusted at 0.25%.
Further, the above-described slurry (1) was re-dried at 70°C for three days, to obtain cerium oxide particles. An average primary particle diameter D2 and a crystallite diameter XS of the cerium oxide particles obtained as above were each measured by the above-described methods. Measurement results are shown in Table 1.

Example 2

To 500 g of a colloidal ceria the same as that of the example 1, injecting colliding processings were performed five times by using the wet jet mill under the same condition as that of the example 1. To 41.6 g of a slurry (2) obtained as above, 4958.4 g of pure water was added and mixed, to obtain a polishing agent (2) whose concentration of abrasive particles was adjusted at 0.25%.
Further, the slurry (2) was re-dried at 70°C for three days, to obtain cerium oxide particles. An average primary particle diameter D2 and a crystallite diameter XS of the cerium oxide particles obtained as above were each measured by the above-described methods. Measurement results are shown in Table 1.

Example 3

To 500 g of a colloidal ceria the same as that of the example 1, injecting colliding processings were performed ten times by using the wet jet mill under the same condition as that of the example 1. To 41.6 g of a slurry (3) obtained as above, 4958.4 g of pure water was added and mixed, to obtain a polishing agent (3) whose concentration of abrasive particles was adjusted at 0.25%.
Further, the slurry (3) was re-dried at 70°C for three days, to obtain cerium oxide particles. An average primary particle diameter D2 and a crystallite diameter XS of the cerium oxide particles obtained as above were each measured by the above-described methods. Measurement results are shown in Table 1.

Example 4

To 500 g of a colloidal ceria the same as that of the example 1, injecting colliding processings were performed thirty times by using the wet jet mill under the same condition as that of the example 1. To 41.6 g of a slurry (4) obtained as above, 4958.4 g of pure water was added and mixed, to obtain a polishing agent (4) whose concentration of abrasive particles was adjusted at 0.25%.
Further, the slurry (4) was re-dried at 70°C for three days, to obtain cerium oxide particles. An average primary particle diameter D2 and a crystallite diameter XS of the cerium oxide particles obtained as above were each measured by the above-described methods. Measurement results are shown in Table 1.

Example 5

To 5000 g of a colloidal ceria (manufactured by Rhodia, trade name: HC60, concentration of abrasive particles: 0.25%, average primary particle diameter D1: 85 nm), injecting colliding processings were performed five times by using the wet jet mill with a pressure being set at 200 MPa, to prepare a polishing agent (5).
Further, the polishing agent (5) was re-dried at 70°C for three days, to obtain cerium oxide particles. An average primary particle diameter D2 and a crystallite diameter XS of the cerium oxide particles obtained as above were each measured by the above-described methods. Measurement results are shown in Table 1.

Example 6

To 5000 g of a colloidal ceria (manufactured by Rhodia, trade name: HC60, concentration of abrasive particles: 0.1%, average primary particle diameter D1: 85 nm), injecting colliding processings were performed five times by using the wet jet mill under the same condition as that of the example 1, to prepare a polishing agent (6). After the polishing agent (6) was re-dried at 70°C for three days to obtain cerium oxide particles, an average primary particle diameter D2 and a crystallite diameter XS of the obtained cerium oxide particles were each measured by the above-described methods. Measurement results are shown in Table 1.

Example 7

To 500 g of a colloidal ceria the same as that of the example 1, injecting colliding processings were performed five times by using the wet jet mill with a pressure being set at 100 MPa. To 41.6 g of a slurry (7) obtained as above, 4958.4 g of pure water was added and mixed, to obtain a polishing agent (7) whose concentration of abrasive particles was adjusted at 0.25%. Further, after the polishing agent (7) was re-dried at 70°C for three days to obtain cerium oxide particles, an average primary particle diameter D2 and a crystallite diameter XS of the obtained cerium oxide particles were each measured by the above-described methods. Measurement results are shown in Table 1.

Example 8

To 41.6 g of a colloidal ceria the same as that of the example 1,4958.4 g of pure water was added and mixed, to obtain a polishing agent (8) whose concentration of abrasive particles was adjusted at 0.25%. Further, after the polishing agent (8) was dried at 70°C for three days to obtain cerium oxide particles, an average primary particle diameter D2 and a crystallite diameter XS of the obtained cerium oxide particles were each measured by the above-described methods. Measurement results are shown in Table 1.

Next, polishing characteristics of the polishing agents (1) to (8) obtained in the examples (1) to (8) were evaluated by a method shown below. Evaluation results are shown in Table 1.

(Evaluation of polishing characteristic)

Experiments to measure polishing speeds were carried out in order to evaluate polishing characteristics.

<Object to be polished>

As a patterned object to be polished, an STI pattern wafer (manufactured by International SEMATECH, trade name: 864CMP000) was used. A wafer size was 8 inches, and in the wafer was formed a plurality of stripe patterns modeling after a pattern of STI, with a pattern width of 0.5 $\mu$m or more to 500 $\mu$m or less and a pattern density of about 10% or more to 90% or less, at a pattern interval of 100 $\mu$m. In the STI pattern wafer, a layer thickness of an SiN layer formed as a mask on an active region was 90 nm, and a depth of a trench was 350 nm. The entire surface of the wafer was covered by a silicon dioxide layer of a layer thickness of 500 nm which was layer-formed from tetraethoxysilane being material, by plasma CVD.

<Polishing machine and polishing condition>

As a polishing machine, a fully automatic CMP apparatus (manufactured by Applied Materials, Inc., apparatus name: Mirra) was used. As a polishing pad, a double layer pad (manufactured by Rodel, Inc., trade name: K-groove, IC-1400) was used, and conditioning was carried out by using a diamond disk (manufactured by 3M Company, trade name: A165). Polishing was performed for two minutes with a supply speed of a polishing agent being 200 $cm^3$/min, the number of rotations of a polishing surface plate being 77 rpm, and a polishing pressure being 3 psi.

Measurement of the polishing speed was carried out by measuring a layer thickness of a part described below of the above-described STI pattern wafer being the object to be polished by using an optical thicknessmeter (manufactured by KLA-Tencor Corporation, apparatus name: UV-1280SE). In other words, from layer thicknesses before and after polishing of a silicon dioxide layer of an active region (element region) portion of a pattern forming part constituted by a trench region of a width of 50 $\mu$m and an active region (element region) of a width of 50 $\mu$m in the above-described STI pattern wafer, the polishing speed was calculated by the following formula.

polishing speed V (nm/min) = (thickness (nm) before polishing – thickness (nm) after 2-minute

polishing) / 2 minute

[Table 1]

| | | Manufacturing condition, etc. | | | | | Polishing agent | | Polishing agent evaluation result | | |
|---|---|---|---|---|---|---|---|---|---|---|---|
| | | Slurry to be used | | | Wet jet mill processing condition | | | | Polishing agent particle | | Polishing characteristic |
| | Colloidal ceria | Concentration of abrasive particles | Average primary particle diameter D1 | Number of injecting colliding processings | Set pressure | Abbreviation | Concentration of abrasive particles | Crystallite diameter XS | Average primary particle diameter D2 | Polishing speed V |
| | | (mass%) | (nm) | (times) | (MPa) | | (mass%) | (nm) | (nm) | (nm/min) |
| Example 1 | HC60 | 30 | 85 | 1 | 200 | (1) | 0.25 | 44 | 85 | 312 |
| Example 2 | HC60 | 30 | | 5 | 200 | (2) | | 45 | 85 | 312 |
| Example 3 | HC60 | 30 | | 10 | 200 | (3) | | 45 | 85 | 312 |
| Example 4 | HC60 | 30 | | 30 | 200 | (4) | | 45 | 85 | 220 |
| Example 5 | HC60 | 0.25 | | 5 | 200 | (5) | | 45 | 85 | 260 |
| Example 6 | HC60 | 0.1 | | 5 | 200 | (6) | | 45 | 85 | 220 |
| Example 7 | HC60 | 30 | | 5 | 100 | (7) | | 45 | 85 | 210 |
| Example 8 | HC60 | 30 | | No processing | | (8) | | 43 | 85 | 110 |

From the results of Table 1, it is found that the average primary particle diameter D does not change before and after the processing by the wet jet mill. It is found that in the polishing agents of the examples 1 to 7 obtained by using the slurries having been subjected to the wet jet mill processings the polishing speeds V were larger compared with the polishing agent obtained by using the slurry without processing in the example 8.

Further, a degree of a single crystal of each abrasive particle shown in Table 1 was found as below. The degrees of the single crystal XS/D in the respective examples are shown in Table 2.

$$\text{degree of single crystal} = \text{crystallite diameter XS} / \text{average primary particle diameter D}$$

[Table 2]

|  | Degree of single crystal XS/D |
| --- | --- |
| Example 1 | 0.52 |
| Example 2 | 0.53 |
| Example 3 | 0.53 |
| Example 4 | 0.53 |
| Example 5 | 0.53 |
| Example 6 | 0.53 |
| Example 7 | 0.53 |
| Example 8 | 0.50 |

From Table 2, in the cerium oxide particles in the polishing agents obtained in the examples 1 to 8, the above-described degrees of a single crystal XS/D are within a range of 0.4 or more to 1 or less.

According to the present invention, it is possible to suppress occurrence of a polishing defect to a surface to be polished and to perform polishing at a high polishing speed Therefore, for example, planarization of an insulation layer for STI can be carried out at a high speed while occurrence of a polishing defect is suppressed, and a manufacturing efficiency of a semiconductor device can be heightened.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

**Claims**

1. A manufacturing method of a polishing agent, comprising:

   injecting a slurry containing cerium oxide particles and water at a predetermined injecting pressure; and colliding the injected slurry against the slurry each other or against a rigid body with a modified Mohs hardness of 8 or more under a condition that a rate of change of an average primary particle diameter of the cerium oxide particles before and after collision is within 20%.

2. The manufacturing method of the polishing agent according to claim 1, wherein the injecting pressure is 100 MPa or more to 400 MPa or less.

3. The manufacturing method of the polishing agent according to claim 1 or 2, wherein a concentration of the cerium oxide particles in the polishing agent is 0.01 mass% or more to 50 mass% or less.

4. The manufacturing method of the polishing agent according to any one of claims 1 to 3,

wherein operation of performing said injecting and colliding in that order is carried out one time or more to forty times or less.

5. A polishing method of performing polishing by a relative motion between a surface to be polished and a polishing pad which are brought into contact with each other while a polishing agent is supplied to the polishing pad, wherein the polishing agent obtained by the manufacturing method according to any one of claims 1 to 4 is used as the polishing agent

6. A manufacturing method of a semiconductor integrated circuit device, comprising polishing the surface to be polished by the polishing method according to claim 5.

# FIG. 1A

# FIG. 1B

# FIG. 2

# FIG. 3

# FIG. 4

**EP 2 899 246 A2**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000109803 A

- JP H0881218 A